# EUROPEAN PATENT SPECIFICATION

(11) **EP 1 691 398 B1**
(45) Date of publication and mention of the grant of the patent: **31.10.2012**
(21) Application number: 04820513.2
(22) Date of filing: 01.12.2004
(51) Int. Cl.: H01L 21/67, H05B 3/14, C04B 37/00

(54) **CERAMIC HEATER UNIT**
KERAMISCHE HEIZEINHEIT
UNITE DE CHAUFFAGE CERAMIQUE

(30) Priority: 01.12.2003 JP 2003401966
(43) Date of publication of application: 16.08.2006
(73) Proprietor: Bridgestone Corporation, Tokyo 104-8340 (JP)
(72) Inventor: YAMAKAWA, Masafumi, Tokyo 187-8531 (JP)
(74) Representative: Oxley, Robin John George
(86) International application number: PCT/JP2004/017877
(87) International publication number: WO 2005/059975

(56) References cited:
- EP-A- 1 199 908
- EP-A- 1 251 719
- WO-A-02/089530
- WO-A1-03/008359
- JP-A- 6 053 145
- JP-A- 2003 040 678

## Description

### FIELD OF THE INVENTION

The present invention relates to a ceramic heater unit.

### BACKGROUND ART

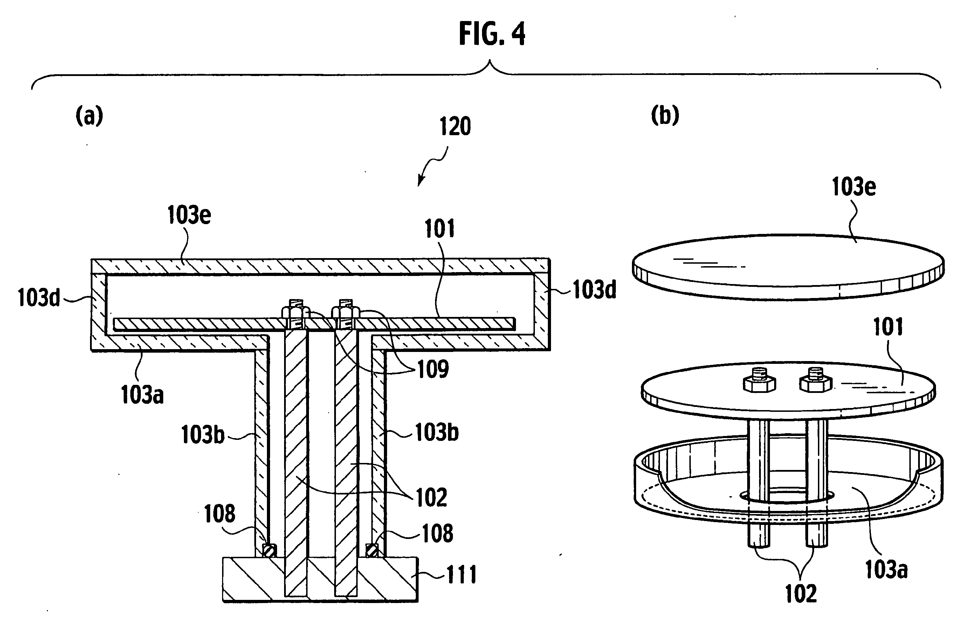

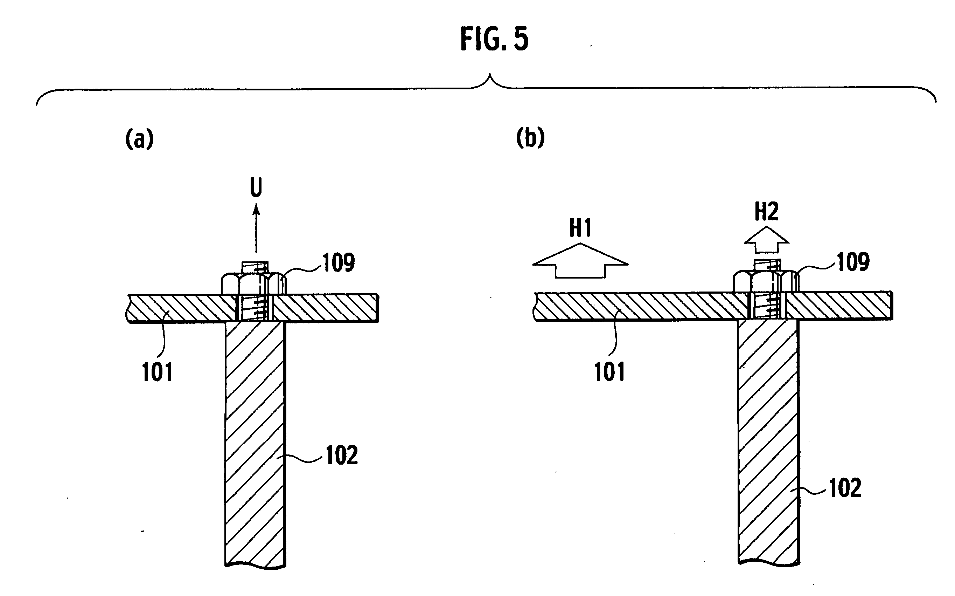

Referring to Figs. 4(a) and 4(b), a conventional ceramic heater unit 120 used for various thermal treatments of a semiconductor wafer has a heater 101 made of silicon carbide and electrodes 102 made of a metal such as nickel for passing electricity through the heater 101 to elevate the temperature thereof. The heater 101 and the electrodes 102 are joined with a nut 109 to be integrated as shown in Fig. 5(a). The integrated heater 101 and electrodes 102 are housed and held in a structure member 103 (See, for example, the Patent Document 1.).

In this case, the nut 109 that joins the heater 101 with the electrodes 102 is constituted of a material such as nickel or molybdenum other than silicon carbide. For this reason, at the time of a thermal treatment of the semiconductor wafer, the constituent components of the nut are deposited as an impurity on the semiconductor wafer surface, as shown in Fig. 5 (a), thereby raising a fear of deterioration in purity. Also, since the thermal characteristics of the members constituting the ceramic heater unit 120 are different, there is also a fear of decrease in thermal uniformity. For example, since the constituent materials of the heater 101 and the nut 109 have different thermal conductivities, a temperature difference has been generated between the heat H1 of the heater 101 and the heat H2 around the joining part of the electrodes 102, as shown in Fig. 5(b). Furthermore, cracks have been generated on the heater member due to the difference in thermal expansivities of the members.

In order to solve the aforementioned problems, the whole heater unit is covered with a structure 103 which is sealed with an O-ring 108 or the like, as shown in Fig. 4 (a). However, this has invited an increase in production costs and a limitation on the design of the ceramic heater unit 120. On the other hand, the object of improvement in the thermal uniformity has not been improved.
Patent Document 1: Japanese Patent Application Laid-Open No. 2002-25751. WO02/089530, EP1,199,908 and EP1,251,719 disclose known ceramic heaters.

### DISCLOSURE OF THE INVENTION

The present invention relates to the following described matters.
(1). A ceramic heater unit having at least a heater and electrodes for passing electricity through above heater to elevate the temperature of the heater, characterized in that above heater and above electrodes are respectively made of a material containing silicon carbide, and above heater and above electrodes are integrally constructed with use of a binder made of a material containing silicon carbide said material containing silicon carbide being a silicon carbide sintered body having a free carbon content of 2 to 10 ut %, and a total content of the impurity elements in said silicon carbide sintered body is 5ppm or less,
(2) The ceramic heater unit of above (1), further having a susceptor placed on a work-facing surface of above heater and made of a material containing silicon carbide.
(3) The ceramic heater unit of above (1) or (2), further having a reflecting plate placed below the surface other than the work-facing surface of above heater and made of a material containing silicon carbide.
(4) The ceramic heater unit of any one of above(1) to (3), further having an insulating plate placed being interposed between above heater and above reflecting plate.
(5) The ceramic heater unit of any one of above(1) to (4), wherein the constituent members of above ceramic heater unit are housed in a case.
(6) The ceramic heater unit of any one of above(1) to (5), wherein above heater and above electrodes are integrally constructed by the reaction sintering method with use of the binder made of a material containing silicon carbide in the part that joins the two.
(7) The ceramic heater unit of any one of (1) above to (5). wherein said binder consists of silicon carbide.

### BRIEF DESCRIPTION OF THE DRAWINGS

Fig. 1 (a) shows a cross-sectional view of a ceramic heater unit of the first embodiment. Fig. 1(b) shows a perspective view of the ceramic heater unit of the first embodiment.
Fig. 2 (a) shows a cross-sectional view of a ceramic heater unit of the second embodiment. Fig. 2 (b) shows a perspective view of the ceramic heater unit of the second embodiment.
Figs. 3(a) to 3(c) are diagrams showing production steps of the first embodiment.
Fig. 4 (a) shows a cross-sectional view of a conventional heater unit. Fig. 4(b) shows a perspective view of the conventional heater unit.
Figs. 5(a) and 5(b) show partially enlarged cross-sectional view of the conventional heater unit.

### BEST MODES FOR CARRYING OUT THE INVENTION

Hereafter, the present invention will be described with reference to embodiments; however, the present invention is not limited to the following embodiments.

### (first embodiment)

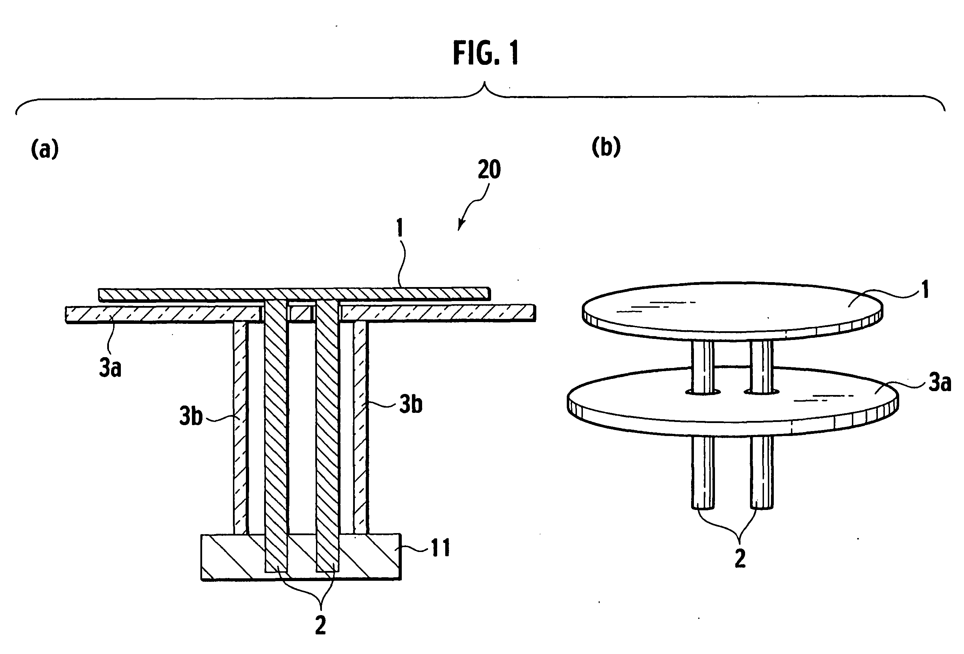

Referring to Figs. 1(a) and 1(b), a ceramic heater unit 20 of the first embodiment has a heater 1 and electrodes 2 for passing electricity through the heater 1 to elevate the temperature of the heater 1. The heater 1 is joined to the electrodes 2 substantially at the center of the surface (lower surface) other than the work-facing surface. The heater 1 is placed on the upper surface of the structure member 3a, and the electrodes 2 penetrate through a through-hole provided in the structure member 3a toward the (lower) side other than the work-facing direction to be connected to a power source (not illustrated). Also, the heater 1 is held by a structure member 3b that is placed to surround the electrodes 2 at the outer circumference of the through-hole located substantially at the center of the lower surface of the structure member 3a to form a hollow cylindrical part and by a base 11 provided at the lower end of the structure member 3b. Here, the structure member 3 is constituted of quartz.

In the first embodiment, the heater 1 and the electrodes 2 are made of a material containing silicon carbide, and are integrally formed with use of a binder made of a material containing silicon carbide. Because of such a construction, the aforesaid problem such as release of an impurity at the time of heating is solved, thereby improving the purity. Also, since the thermal characteristics of the heater 1 and the binder are the same, there will be no difference in temperature between the heater 1 main body and the part joined to the electrodes 2, thereby improving the thermal uniformity. Further, there will be no fear of cracks that have been generated due to the difference in the thermal characteristics of the heater members.

### (production method)

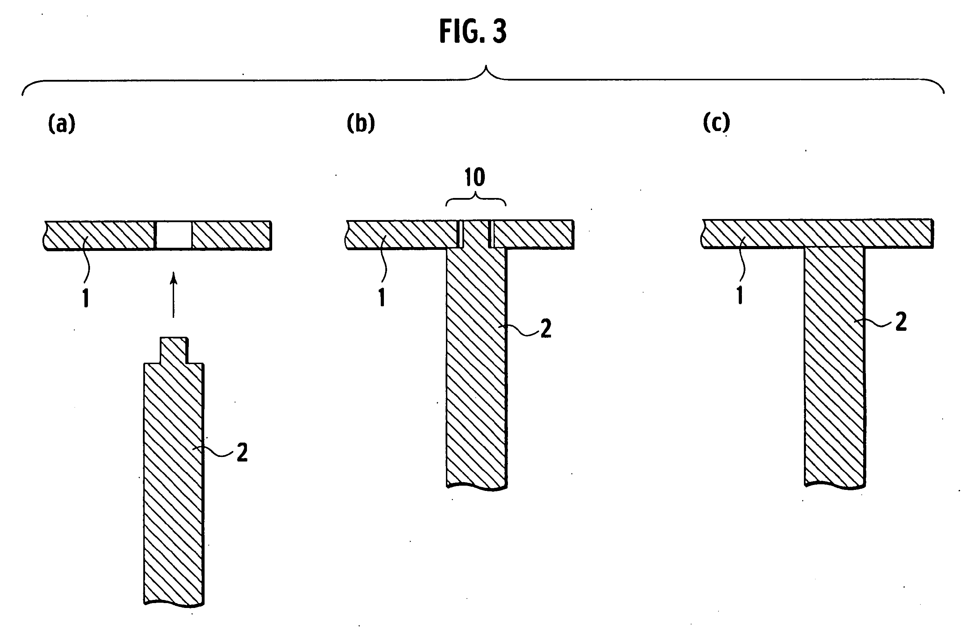

First, the heater 1 and the electrodes 2 constituting the ceramic heater unit 20 are produced from silicon carbide in accordance with the hot pressing method described later. During this, the heater 1 and the electrodes 2 are made joinable (Fig. 3 (a)). Also, a communication hole is provided in a part of the heater 1 and a projection is formed at one end of the electrodes 2 so that an allowance is formed at the joining part 10 when they are joined (Fig. 3(b)).

Next, as shown in Fig. 3(b), a slurry containing silicon carbide (SiC) and carbon (C) is poured into the joining part 10 of the heater 1 and the electrodes 2. Thereafter, the joining part is heated. Subsequently, a high-purity silicon (Si) is inserted into the joining part, so as to allow excessive C and Si to react to form SiC. Due to such reaction sintering method, the heater 1 and the electrodes 2 are integrated as shown in Fig. 3(c).

Further, by assembling the structure members 3a, 3b, the ceramic heater unit 20 shown in Fig. 1(a) is produced.

Here, the silicon carbide of the above-described heater and electrodes has been produced by the hot pressing method. However, the above-described heater and electrodes may be produced by other production methods, for example, the reaction sintering method or an improved method thereof.

### (second embodiment)

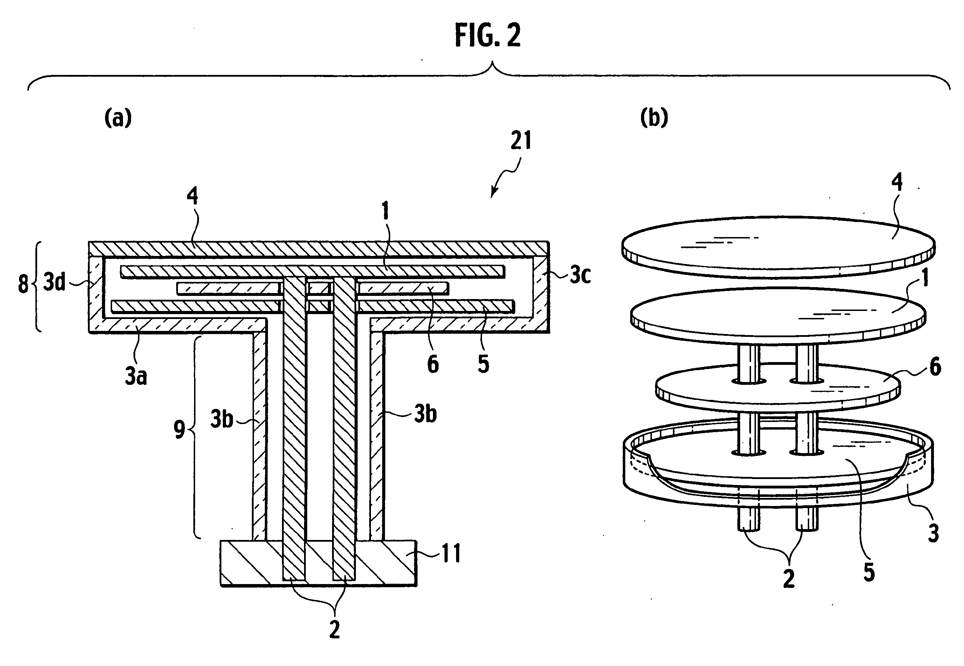

Description will be made on the second embodiment having a susceptor and a reflecting plate in addition to the constituent elements of the first embodiment.
Referring to Figs. 2(a) and 2(b), a ceramic heater unit 21 of the second embodiment is provided with a susceptor 4 that allows a work to be placed thereon, a heater 1 placed on the surface (lower surface) side other than the work-facing surface (upper surface) of the susceptor 4, electrodes 2 joined substantially to the center of the lower surface of the heater 1 for passing electricity through the heater 1 to elevate the temperature of the heater 1, an insulating plate 6 placed on the lower surface of the heater 1, and a reflecting plate 5 placed below the heater 1 with the insulating plate 6 interposed therebetween. The electrodes 2 are constructed to extend downwards through a through-hole provided substantially at the center of the insulating plate 6 and the reflecting plate 5 so as to be connected to a power source (not illustrated).

Further, the second embodiment has a first hollow cylindrical part 8 that includes a lid portion formed by the susceptor 4, a bottompart 3a on which the heater 1, the insulating plate 6, and the reflecting plate 5 are placed and which has a through-hole substantially at the center so that the electrodes 2 can penetrate therethrough, and a wall part 3d provided at the peripheries of the bottom part 3a to form a hollow cylindrical part. Also, the second embodiment includes a second hollow cylindrical part 9 which is provided at the outer circumference of the through-hole of the bottom part 3a to surround the electrodes 2 that penetrate through the bottom part 3a and which holds the first hollow cylindrical part 8 and has a base 11 at an end. Namely, in the second embodiment, the constituent members of the above-described ceramic heater unit 21 are housed within a case that is formed with the first and second hollow cylindrical parts 8, 9.

In the second embodiment, the heater 1, the electrodes 2, the susceptor 4, and the reflecting plate 5 are made of a material containing silicon carbide, and the heater 1 and the electrodes 2 are integrally formed with use of a binder made of a material containing silicon carbide. By providing a susceptor 4, the thermal uniformity is further improved. This is because of its high thermal conductivity. Also, by providing a reflecting plate 5, a good thermal efficiency is obtained so as to improve thermal uniformity. By adjusting the lower surface of the reflecting plate 5 to have a higher thermal conductivity than the upper surface thereof, the thermal uniformity will be effectively improved. The insulating plate 6 is constituted of quartz or the like.

The second embodiment produces a function and effect of improving the corrosion resistance of the ceramic heater unit 21 because the constituent members of the ceramic heater unit 21 are housed within a case.

The heater 1 and the electrodes 2 as well as the susceptor 4 and the reflecting plate 5 constituting the second embodiment are produced by the hot pressing method in the same manner as in the first embodiment. Also, the heater 1 and the electrodes 2 may be produced by the reaction sintering method in the same manner as in the first embodiment. Here, the description on the method of producing the second embodiment will be omitted.

### (hot pressing method)

Hereafter, description will be made on a method of producing silicon carbide that is used for production of a heater unit.
In the method of producing a heater unit of the present invention, it is preferable to use a silicon carbide sintered body having a free carbon content of 2 to 10 wt%. Such a silicon carbide sintered body is obtained by sintering a mixture of silicon carbide powder and a non-metallic sintering auxiliary. First, the silicon carbide powder will be described. As the silicon carbide powder, one can widely use an α-type, a β-type, an amorphous one, a mixture of them, or the like, and one can also use a commercially available one as well. Among them, a β-type silicon carbide powder is suitably used. In order to obtain a silicon carbide sintered body with higher density, the silicon carbide powder to be used preferably has a smaller particle size. Preferably, it is about 0.01 to 10 µm, more preferably 0.05 to 2 µm. When the particle size is smaller than 0.01 µm, the handling in the processing steps such as measuring and mixing will be difficult. On the other hand, when the particle size exceeds 10 µm, the specific surface area of the powder, namely the contact area with adjacent power, will be small and it will be difficult to achieve a high density, so that it is not preferable.

When a silicon carbide powder having a high purity is used, the obtained silicon carbide sintered body will also have a high purity, so that it is preferable. A silicon carbide powder having a high purity can be produced, for example, by mixing a silicon compound (which may hereafter be referred to as "silicon source"), an organic material that generates carbon by being heated, and a Z-polymerization catalyst or a cross-linking catalyst, and sintering the obtained solid substance in a non-oxidizing atmosphere. As the silicon source, one can widely use compounds in a liquid form and in a solid form. At least one kind of a compound in a liquid form is used. A silicon source in a liquid form may be, for example, a polymer of alkoxysilane (mono-, di-, tri-, tetra-) or the like. Among the polymers of alkoxysilane, a polymer of tetraalkoxysilane is suitably used. Specific examplesinclude methoxysilane,ethoxysilane,propyloxysilane, butoxysilane, and the like, and in view of handling, ethoxysilane is preferable. When the polymerization degree of a tetraalkoxysilane polymer is about 2 to 15, it will be a low molecular weight polymer (oligomer) in a liquid form. In addition, some of the silicic acid polymers having a high polymerization degree are in a liquid form. A silicon source in a solid form that can be used with a silicon source in a liquid form in combination may be, for example, silicon carbide. The silicon carbides as referred to herein include, in addition to silicon monoxide (SiO) and silicon dioxide (SiO₂), silica sol (colloidal superfine silica-containing liquid having an OH group or an alkoxy group in a colloid molecule), fine silica, quartz powder, and the like as well. Among them silicon sources, an oligomer of tetraalkoxysilane having a good homogeneousness and a good handling property, or a mixture of an oligomer of tetraalkoxysilane and a fine powder silica, or the like is preferable. Also, these silicon sources preferably have a high purity. Specifically, the initial impurity content is at most 5 ppm.

As an organic material that produces carbon by being heated, in addition to those in a liquid form, one can use those in a liquid form and those in a solid form in combination. An organic material having a high residual carbon ratio and being polymerized or cross-linked by a catalyst or by being heated is preferable. Specifically, monomers and prepolymers of phenolic resin, furan resin, polyimide, polyurethane, polyvinyl alcohol, and the like are preferable. In addition, those in a liquid form such as cellulose, sucrose, pitch, and tar are used as well. Among them, a resol-type phenolic resin is preferable in view of thermal decomposition property and purity. The purity of an organic material may be suitably controlled in accordance with an intended object. In particular, when a silicon carbide powder having a high purity is needed, it is preferable to use organic materials each having an impurity element content of less than 5 ppm.

A preferable range of the ratio of blending a silicon source with an organic material can be determined in advance using the molar ratio of carbon to silicon (which will hereafter be abbreviated as "C/Si") as a target. The C/Si as referred to herein is the C/Si obtained from an analysis value by subjecting a silicon carbide intermediate, which is produced by carbonizing a mixture of a silicon source and an organic material at 1000°C, to an element analysis. Carbon reacts with silicon oxide to be changed into silicon carbide, as expressed by the following reaction formula.

In accordance with the formula (I) SiO₂ + 3C → SiC + 2CO, the free carbon in a silicon carbide intermediate will be stoichiometrically 0% when the C/Si is 3.0. However, in actual cases, SiO gas and the like are volatilized, so that free carbon is generated even if the C/Si is a lower value. Since free carbon produces an effect of restraining the particle growth, the C/Si may be determined in accordance with the intended particle size of the powder particles, and the silicon source and the organic material may be blended so as to achieve the ratio. For example, in the case of sintering a mixture of a silicon source and an organic material under about one atmospheric pressure at 1600°C or higher, the generation of free carbon can be restrained when they are blended so that the C/Si will be in a range from 2.0 to 2.5. When they are blended so that the C/Si will exceed 2.5 under the same condition, the generation of free carbon will be conspicuous, and a silicon carbide powder having a small particle size can be obtained. Thus, the blending ratio can be suitably determined in accordance with the intended object. Here, the function and effect of the free carbon deriving from silicon carbide powder is extremely weak as compared with the function and effect of the free carbon produced from a sintering auxiliary. Therefore, the free carbon deriving from silicon carbide powder essentially does not affect the effect of the present invention.

The total amount of carbon contained in the silicon carbide powder is preferably about 30 wt% or higher and about 40 wt% or lower. The total carbon content of silicon carbide (SiC) is theoretically about 30 wt%; however, the total carbon content decreases to be lower than 30 wt% when the silicon carbide contains a non-carbon impurity, and increases to be higher than 30 wt% when the silicon carbide contains free carbon. The silicon carbide powder obtained by adding an organic material and sintering as described above contains a carbon impurity, so that the carbon content will be higher than 30 wt%. Therefore, when the carbon content in the silicon carbide powder is less than 30 wt%, the ratio of non-carbon impurity is high, so that it is not preferable in view of purity. On the other hand, when the carbon content exceeds 40 wt%, the density of the obtained silicon carbide powder will decrease. so that it is not preferable in view of strength, oxidation resistance, and the like.

The mixture of a silicon source and an organic material can be hardened to be made into a solid substance. As a method of hardening, there are a method of using a cross-linking reaction by heating, a method of hardening with use of a hardening catalyst, a method of using an electron beam or radioactive rays, and the like. The hardening catalyst to be used can be suitably selected in accordance with the organic material to be used. Whenphenolic resin or furan resin is used as the organicmaterial, the hardening catalyst may be, for example, a carboxylic acid such as toluenesulfonic acid, toluenecarboxylic acid, acetic acid, or oxalic acid, an inorganic acid such as hydrochloric acid or sulfuric acid, an amine such as hexamine, or the like. A solid substance containing a silicon source and an organic material is heated and carbonized in accordance with the needs. The carbonization is carried out by heating at 800°C to 1000°C for 30 to 120 minutes in a non-oxidizing atmosphere such as nitrogen or argon. Silicon carbide is produced when the solid substance is further heated at 1350°C to 2000°C in a non-oxidizing atmosphere. The sintering temperature and the sintering time may be suitably determined because they affect the particle size of the obtained silicon carbide powder and the like. It is efficient and preferable to sinter the solid substance at 1600°C to 1900°C. The method of obtaining a high-purity silicon carbide powder described above is disclosed in detail in the specification of Japanese Patent Application Laid-Open No. 09-48605.

Next, the non-metallic sintering auxiliary will be described. The silicon carbide sintered body used in the present invention is one containing free carbon at 2 to 10 wt%. This free carbon derives from the organic material used in the non-metallic sintering auxiliary. The amount of free carbon can be set within the above-described range by adjusting an addition condition such as an amount of addition of a non-metallic sintering auxiliary.

As the non-metallic sintering auxiliary, those being capable of becoming a free carbon source as described above, namely those containing an organic material that produces carbon by being heated (which may hereafter be referred to as "carbon source"), are used. The above-described organic materials alone, or those obtained by covering the silicon carbide powder (particle size: about 0.01 to 1 micron) surface with the above-described organic materials may be used as the sintering auxiliary. In view of the effect, it is preferable to use organic materials alone. Specific examples of the organic materials that produce carbon by being heated include various sugars, for example, monosaccharides such as glucose, oligosaccharides such as sucrose, and polysaccharides such as cellulose and starch in addition to coal tar pitch, pitch tar, phenolic resin, furan resin, epoxy resin, and phenoxy resin having a high residual carbonization ratio. In order to mix an organic material homogeneously with silicon carbide powder, the organic material is preferably one that is in a liquid form at an ordinary temperature, one that is dissolved into a solvent, or one that is softened by being heated, such as those having a thermoplasticity or thermofusion property. Among them, the use of phenolic resin is preferable since the strength of the silicon carbide sintered body will be improved. Furthermore, a resol-type phenolic resin is preferable. The action mechanism of these organic materials is not made clear yet. However, it is assumed that an inorganic carbon compound such as carbon black or graphite, which is produced by heating an organic material in the system, acts effectively as a sintering auxiliary. However, if carbon black or the like is used as a sintering auxiliary, similar effects are not obtained.

The non-metallic sintering auxiliary may be dissolved in an organic solvent as desired, and the solution may be mixed with the silicon carbide powder. The organic solvent to be used may be different depending on the non-metallic sintering auxiliary. For example, when phenolic resin is to be used as the sintering auxiliary, a lower alcohol such as ethyl alcohol, ethyl ether, acetone, or the like can be selected. In the case of fabricating a silicon carbide sintered body having a high purity, it is preferable to use a sintering auxiliary and an organic solvent having a smaller impurity content in addition to using a silicon carbide powder having a high purity.

The amount of the non-metallic sintering auxiliary to be added to the silicon carbide powder is determined so that the free carbon of the silicon carbide sintered body will be 2 to 10 wt%. When the free carbon is out of this range, the chemical change to SiC that proceeds during the joining process and the joining between the silicon carbide sintered bodies will be insufficient. Here, the content (wt%) of free carbon can be calculated from a value obtained by measuring the amount of CO₂ and CO generated by heating a silicon carbide sintered body at 800°C for 8 minutes in an oxygen atmosphere with a carbon analysis apparatus. The amount of the sintering auxiliary to be added differs depending on the kind of the sintering auxiliary to be used and the amount of surface silica (silicon oxide) of the silicon carbide powder. As a target for determining the amount of addition, the amount of surface silica (silicon oxide) of the silicon carbide powder is quantitated in advance with use of hydrogen fluoride water, and the stoichiometrical amount sufficient to reduce this silicon oxide (stoichiometrical amount calculated by the formula (I)) is calculated. By considering this value and the ratio by which the non-metallic sintering auxiliary produces carbon by being heated, the amount of addition can be determined so that the free carbon will be in the above-described suitable range. The description on the non-metallic sintering auxiliary of the silicon carbide sintered body described above is disclosed in more detail in the specification of Japanese Patent Application No. 09-041048.

Next, a method of sintering a mixture of silicon carbide powder and a non-metallic sintering auxiliary will be described. The silicon carbide powder and the non-metallic sintering auxiliary are homogeneously mixed. In order to obtain a homogeneous mixture, a solution obtained by dissolving the sintering auxiliary into an organic solvent may be used, as described before. The mixing method may be a known one, for example, a method using a mixer, a planetary ball mill, or the like. An instrument used for mixing is preferably made of a synthetic resin material in order to prevent intermingling of metal element impurities. The mixing is preferably carried out for about 10 to 30 hours, particularly for 16 to 24 hours, so as to perform sufficient mixing. After sufficient mixing, the solvent is removed, so as to solidify the mixture by evaporation. Thereafter, the mixture is subjected to sieving to obtain a source material powder of the mixture. For drying, a granulation apparatus such as a spray dryer may be used.

The source material powder obtained in this manner is placed in a formingmold. The use of formingmoldmade of graphite is preferable since metal impurities will not intermingle into the silicon carbide sintered body. Even a forming mold made of a metal can be suitably used if the contact part between the source material and the mold is made of graphite or a tritetrafluoroethylene sheet (trade name: teflon sheet) is interposed at the contact part so that the source material powder may not be in direct contact with the metal part of the mold. In particular, if one wishes to produce a silicon carbide sintered body having a high purity, it is preferable that the mold and the heat-insulating material or the like within the furnace are made of a graphite material having a high purity. Specifically, an example is, a graphite material or the like that is sufficiently subjected to a baking process at a temperature of 2500°C or higher in advance and that does not generate an impurity even when used at a high temperature.

The source material powder placed in the forming mold is subjected to a hot-pressing treatment. As to the pressure for hot pressing, the hot pressing can be carried out under a pressure in a wide range of 2.94.10⁷ to 6.86.10⁷ Pa (300 to 700 kgf/cm²). However, when pressurization is carried out at 3.92.10⁷ Pa (400 kgf/cm²) or higher, the parts for hot pressing, for example, the dice, the punches, and the like to be used must have an excellent pressure resistance.

The hot pressing is carried out at 2000°C to 2400°C. The temperature raising up to this hot pressing treatment temperature is preferably carried out gradually and stepwise. When the temperature is raised in this manner, the chemical change, the state change, and the like that are generated at each temperature can be allowed to proceed sufficiently, and as a result, the intermingling of impurities and the generation of cracks and pores can be prevented. A preferable example of the temperature raising step will be shown below. First, a forming mold containing 5 to 10 g of a source material powder is placed within a furnace, and the inside of the furnace is brought into a vacuum state of 0.0133 Pa (10⁻⁴ torr). The temperature is raised gradually from room temperature to 200°C, and is maintained at 200°C for about 30 minutes. Thereafter, the temperature is raised to 700°C in 6 to 10 hours, and is maintained at 700°C for 2 to 5 hours. In the temperature raising step from room temperature to 700°C, elimination of adsorbed moisture and organic solvent takes place, and carbonization of the non-metallic sintering auxiliary also proceeds. The period of time for holding a predetermined temperature differs depending on the size of the silicon carbide sintered body, and may be suitably set to a preferable period of time. Also, whether the holding time is sufficient or not can be determined by using as a target the time point at which the decrease in the vacuum degree becomes small to a certain degree. Next, the temperature is raised from 700°C to 1500°C in 6 to 9 hours, and is maintained at 1500°C for about 1 to 5 hours. While the temperature is maintained at 1500°C, the reaction of silicon oxide being reduced to change into silicon carbide proceeds (formula (I)). If the holding time is insufficient, silicon dioxide remains and adheres to the silicon carbide powder surface. This hinders the densification of the particles and causes growth of large particles, so that it is not preferable. Whether the holding time is sufficient or not can be determined using, as a target, whether the generation of carbon monoxide, which is a byproduct, has stopped or not, namely whether the decrease in the vacuum degree has ceased and has recovered to the vacuum degree of 1300°C which is the temperature at the start of reduction reaction or not.

The hot pressing is preferably carried out after the temperature inside the furnace is raised to about 1500°C at which the sintering starts and then the inside of the furnace is filled with an inert gas so as to provide a non-oxidizing atmosphere. As the inert gas, nitrogen gas, argon gas, or the like is used; and it is preferable to use argon gas which is non-reactive even at a high temperature. If one wishes to produce a high-purity silicon carbide sintered body, a high-purity inert gas is used. After the inside of the furnace is made into a non-oxidizing atmosphere, the inside of the furnace is heated and pressurized so as to obtain the temperature of 2000°C to 2400°C and the pressure of 2.94.10⁷ to 6.86.10⁷ Pa (300 to 700 kgf/cm²). If the maximum temperature is lower than 2000°C, the achievement of high density will be insufficient. On the other hand, if the maximum temperature exceeds 2400°C, there is a fear that the powder or the source material of the molded product will be sublimated (decomposed), so that it is not preferable. It is preferable that the temperature is raised from approximately 1500°C to the maximum temperature in 2 to 4 hours, and the maximum temperature is maintained for 1 to 3 hours. The sintering proceeds rapidly at 1850°C to 1900°C, and the sintering is completed while the maximum temperature is maintained. When the pressurization condition is less than 2.94.10⁷ Pa (300 kgf/cm²), the achievement of high density will be insufficient, whereas when it exceeds 6.86.10⁷ Pa (700 kgf/cm²), the forming mold made of graphite may possibly be destroyed, so that it is not preferable in view of the production efficiency. The pressurization is preferably carried out at about 2.94.10⁷ to 6.86.10⁷ Pa (300 kgf/cm² to 700 kgf/cm²) so as to restrain the growth of abnormal particles.

The silicon carbide sintered body to be used is preferably highly densified to have a density of 2.9 g/cm³ or more and a pore ratio of 1% or less, particularly preferably a density of 3.0 g/cm³ or more and a pore ratio of 0.8% or less. The use of a highly densified silicon carbide sintered body improves the mechanical characteristics such as flexural strength and breakage strength as well as electrical physical properties of the obtained silicon carbide joined body. Also, the use of a highly densified silicon carbide sintered body is preferable in view of the contamination property since the constituent particles are made into small-size particles . On the other hand, when a low-density silicon carbide sintered body, for example, a porous silicon carbide sintered body is used, the silicon carbide joined body will be inferior in heat resistance, oxidation resistance, chemical resistance, and mechanical strength, and also joining strength will be insufficient in some cases.

As a method for highly densifying the silicon carbide sintered body, there is a method of performing a molding step in advance prior to the sintering step. This molding step is carried out at a low temperature and under a low pressure as compared with the sintering step. When this sintering step is carried out, a bulky powder can be made compact (reduced in volume) in advance. Therefore, by repeating this step for a number of times, production of a large-scalemoldedproduct is facilitated. One example of various conditions in the molding step carried out in advance prior to the sintering step is shown below. A sourcematerial powder obtained by homogeneouslymixing a silicon carbide powder and a non-metallic sintering auxiliary is placed in a forming mold, and is pressed at a temperature of 80°C to 300°C, preferably 120°C to 140°C, and under a pressure of 4.9.10⁶ to 9.8.10⁶ Pa (50 kgf/cm² to 100 kgf/cm²) for 5 to 60 minutes, preferably for 20 to 40 minutes to obtain a molded product. The heating temperature may be suitably determined in accordance with the characteristics of the non-metallic sintering auxiliary. The source material powder is preferably pressed so that the obtained molded product will have a density of 1.8 g/cm² or more when a powder having an average particle size of about 1 µm is used, or so that the obtained molded product will have a density of 1.5 g/cm² when a powder having an average particle size of 0.5 µm is used. The use of the molded product having a density within this range is preferable since the high densification of the silicon carbide sintered body will be facilitated. The molded product may be subj ected to a cutting process so that the obtained molded product will conform to the forming mold used in the sintering step.

When the total content of the impurity elements (elements having an atomic number of 3 or more excluding C, N, O, and Si in the element periodic table of the revised IUPAC Inorganic Chemistry Nomenclature of the year 1989) in the silicon carbide sintered body used in the present invention is 5 ppm or less, it is preferable because it can be used also in a process that demands a high cleanness, for example, in a semiconductor production process. More preferably, the total content is 3 ppm or less, particularly preferably 1 ppm or less. However, the impurity content by chemical analysis has a meaning only as a reference value in the case of actual use. For example, even if the impurity content is the same, the evaluation of the contamination property on the silicon carbide joined body may differ in some cases depending on whether the impurities are uniformly distributed or locally present. Here, by using the materials specifically exemplified in the above and the exemplified sintering method, a silicon carbide sintered body having an impurity content of 1 ppm or less is obtained. In order to reduce the impurity element content of the silicon carbide sintered body, there are methods in which the content of the impurity elements contained in the source material to be used (for example, a silicon carbide powder and a non-metallic sintering auxiliary) and in the inert gas is set to be 1 ppm or less, or various conditions of sintering such as the sintering time and the temperature are adjusted to remove the impurities, and the like methods. Here, the impurity elements as referred to herein are the same as described above, and refer to the elements having an atomic number of 3 or more (excluding C, N, O, and Si) in the periodic table of the revised IUPAC Inorganic Chemistry Nomenclature of the year 1989.

As to the other physical property values of the silicon carbide sintered body used in the present invention, it is preferable that the flexural strength at room temperature is 5.39.10⁹ to 7.84.10⁹ Pa (550 to 800 kgf/mm²); Young's modulus is 3.5 × 10⁴ to 4.5 × 10⁴; the Vickers hardness is 5.39.10⁹ to 7.84.10⁹ Pa (550 to 800 kgf/mm²); Poisson's ratio is 0.14 to 0.21; the thermal expansion coefficient is 3.8 × 10⁻⁶ to 4.2 × 10⁻⁶ l/°C; the thermal conductivity is 150 W/m·K or more; the specific heat is 0.63 to 0.75 J/g·K (0.15 to 0.18 cal/g·°C); the heat shock resistance is 500 to 700 ΔT°C; and the specific resistance is 1 Ω·cm, because then various properties of the obtained silicon carbide sintered body will be good. Here, as the silicon carbide sintered body of the present invention, a silicon carbide sintered body disclosed in Japanese Patent Application No. 09-041048 of the present inventors can be suitably used.

Also, the surface on which the silicon carbide sintered body is joined is preferably smooth in view of close adhesion. Specifically, the surface roughness Ra of the surface to be joined is preferably 0.5 µm or less, more preferably 0.02 µm or less. The surface roughness of the silicon carbide sintered body can be adjusted to be within the above-described range by performing a grinding process with use of a grinding wheel having a mesh of 200 to 800, buff processing, or the like.

Next, the silicon metal used as a binder will be described. The silicon metal used in the present invention preferably has a purity of 98% or higher, more preferably a purity of 99% or higher, particularly preferably a purity of 99.9%. When a silicon metal having a low purity is used, a shared compound due to the impurity elements is produced in the silicon carbide joined body, thereby decreasing the fire resistance. Particularly, when it is to be used for a semiconductor process-related purpose such as in a wafer jig, the silicon metal preferably has a purity of 99.999% or higher. When the silicon metal put to use is a powder, the powder preferably has a mesh of 100 or more. When the size of the silicon metal is less than 100 mesh, the joined surface is liable to be shifted, making it impossible to obtain a dimension precision. The upper limit value is not particularly limited; however, actually available ones have a mesh of 350 or less.

The amount of the silicon metal used for joining affects the joining strength and the like of the obtained silicon carbide joined body. As a result of eager studies by the present inventors and others, it has been found out that, when a silicon metal of an amount calculated in accordance with the following formula (1) is used, the joining strength of the obtained silicon carbide joined body will be good, and also no decrease in the joining strength or contamination due to the remaining of the siliconmetal occurs. Formula (1) k × {surface area of the joined surface of the silicon carbide joined body (cm²)} × {amount of free carbon of the silicon carbide sintered body (%)} (g). In the formula, the surface area of the joined surface of the silicon carbide joined body represents the surface area as viewed in the plane of projection of the joined surface. For example, in the case of joining two sintered bodies having an identical surface, it represents the surface area as viewed in the plane of projection of the surface of one silicon carbide sintered body. In the case of joining three or more silicon carbide sintered bodies, it represents half of the area of the sum of the surface areas of all of the joined surfaces of the silicon carbide sintered bodies as viewed in the plane of projection. In the formula, k is 0.08 to 0.12, and is a coefficient that has been experimentally determined. The dimension thereof will be g/cm².

The silicon metal is interposed and sandwiched between the surfaces of the two or more silicon carbide sintered bodies that are joined. For example, a silicon metal powder may be scattered on the surface of one silicon carbide sintered body, and then the joining surface of the other silicon carbide sintered body may be superposed on the surface on which the silicon metal has been scattered, or else two or more silicon carbide sintered bodies may be placed close to each other so as to obtain a predetermined space (placed so that the joining surfaces may oppose to each other) and the space may be filled with a metal silicon powder. During this period, there is no need for pressurization. For example, in the case of joining the silicon carbide sintered bodies in a superposed state, it is sufficient as long as the surfaces are not shifted even if loaded only with the self-weight of the silicon carbide sintered bodies. They may be fixed with a fixing tool or pressurized so that the surfaces may not be shifted. As a method for scattering a silicon metal on the surface of a silicon carbide sintered body, there is for example a method in which all of the surface of the silicon carbide sintered body is covered with the silicon metal with use of a funnel or the like.

Next, the silicon carbide sintered bodies that sandwich the silicon metal are subjected to a high-temperature heating treatment. The heating treatment is preferably carried out in a non-oxidizing atmosphere, and preferably carried out in vacuum or in an inert gas atmosphere other than nitrogen gas. The inert gas to be used is preferably argon gas or helium gas. When nitrogen gas is used as the inert gas, it reacts with silicon metal at a high temperature to produce silicon nitride, whereby the joined surface may sometimes be exfoliated or destroyed due to the thermal expansion difference. On the other hand, argon gas and helium gas are preferable since such a problem is not occurred for they are non-reactive even at a high temperature. Here, if one wishes to produce a high-purity silicon carbide joined body, the inert gas to be used preferably has a high purity also.

It is sufficient that the heating temperature is at lowest the melting point of the silicon metal, preferably 1450°C to 2200°C. When the heating temperature is lower than 1450°C. the silicon metal will not be melted, whereas when it is 2200°C, part of the silicon metal will be sublimated. When silicon carbide of β-type is used as a source material, the upper limit is preferably set to be 2000°C. When silicon carbide of α-type is used, the upper limit is preferably set to be 1800°C. Particularly, joining at about 1600°C is preferable since a joined body having a high strength can be produced efficiently. Also, when the temperature is gradually raised, the reaction of silicon metal with the free carbon in the silicon carbide sintered body will proceed sufficiently, so that it is preferable. Specifically, the temperature is raised preferably at 5°C/min to 15°C/min, particularly at about 10°C/min.

### INDUSTRIAL APPLICABILITY

According to the ceramic heater unit of the present invention, an improvement in the purity and in the thermal uniformity can be achieved.

## Claims

1. A ceramic heater unit (20, 21) comprising at least a heater (1) and electrodes (2) for passing electricity through said heater to elevate the temperature of the heater, **characterized in that** said heater and said electrodes are respectively made of a material containing silicon carbide, and said heater and said electrodes are integrally constructed with use of a binder made of a material containing silicon carbide, said material containing silicon carbide being a silicon carbide sintered body having a free carbon content of 2 to 10 wt%, and a total content of the impurity elements in said silicon carbide sintered body is 5 ppm or less.

2. The ceramic heater unit of claim 1, further comprising a susceptor (4) placed on a work-facing surface of said heater and made of a material containing silicon carbide.

3. The ceramic heater unit of claim 1 or 2, further comprising a reflecting plate (5) placed below the surface other than the work-facing surface of said heater and made of a material containing silicon carbide.

4. The ceramic heater unit of any one of claims 1 to 3, further comprising an insulating plate (6) placed being interposed between said heater and said reflecting plate.

5. The ceramic heater unit of any one of claims 1 to 4, wherein the constituent members of said ceramic heater unit are housed in a case.

6. The ceramic heater unit of any one of claims 1 to 5, wherein said heater and said electrodes are integrally constructed by the reaction sintering method with use of the binder made of a material containing silicon carbide in the part that joins the two.

7. The ceramic heater unit of any one of the preceding claims, wherein said binder consists of silicon carbide.

## Patentansprüche

1. Keramische Heizereinheit (20, 21), umfassend mindestens einen Heizer (1) und Elektroden (2) zum Leiten von Elektrizität durch den Heizer, um die Temperatur des Heizers zu erhöhen, **dadurch gekennzeichnet, dass** der Heizer und die Elektroden jeweils aus einem siliziumkarbidhaltigen Material hergestellt sind und dass der Heizer und die Elektroden in einem Stück konstruiert sind, und zwar unter Verwendung eines aus einem siliziumkarbidhaltigen Material hergestellten Binders, wobei das siliziumkarbidhaltige Material ein Siliziumkarbid-Sinterkörper mit einem Anteil freien Kohlenstoffs von 2 bis 10 Gewichtsprozent ist und ein Gesamtanteil der Verunreinigungselemente in dem Siliziumkarbid-Sinterkörper 5 ppm oder weniger beträgt.

2. Keramische Heizereinheit nach Anspruch 1, ferner einen Suszeptor (4) umfassend, der auf einer arbeitsseitigen Oberfläche des Heizers platziert ist und aus einem siliziumkarbidhaltigen Material hergestellt ist.

3. Keramische Heizereinheit nach Anspruch 1 oder 2, ferner eine reflektierende Platte (5) umfassend, die unter der anderen als der arbeitsseitigen Oberfläche des Heizers platziert ist und aus einem siliziumkarbidhaltigen Material hergestellt ist.

4. Keramische Heizereinheit nach einem der Ansprüche 1 bis 3, ferner eine isolierende Platte (6) umfassend, die zwischen dem Heizer und der reflektierenden Platte eingesetzt ist.

5. Keramische Heizereinheit nach einem der Ansprüche 1 bis 4, worin die Bestandteile der keramischen Heizereinheit in einem Gehäuse untergebracht sind.

6. Keramische Heizereinheit nach einem der Ansprüche 1 bis 5, worin der Heizer und die Elektroden durch das Reaktionssinterverfahren in einem Stück konstruiert sind, und zwar unter Verwendung des aus einem siliziumkarbidhaltigen Material hergestellten Binders in dem Teil, der die beiden verbindet.

7. Keramische Heizereinheit nach einem der vorhergehenden Ansprüche, worin der Binder aus Siliziumkarbid besteht.

## Revendications

1. Unité de chauffage céramique (20, 21) comprenant au moins un élément chauffant (1) et des électrodes (2) destinées à faire passer de l'électricité à travers ledit élément chauffant pour élever la température de l'élément chauffant, **caractérisée en ce que** ledit élément chauffant et lesdites électrodes sont respectivement constitués d'un matériau contenant du carbure de silicium, et ledit élément chauffant et lesdites électrodes sont construits d'un seul tenant avec utilisation d'un liant constitué d'un matériau contenant du carbure de silicium, ledit matériau contenant du carbure de silicium étant un corps fritté en carbure de silicium ayant une teneur en carbone libre de 2 à 10 % en poids, et une teneur totale en éléments d'impureté dans ledit corps fritté en carbure de silicium étant de 5 ppm ou moins.

2. Unité de chauffage céramique selon la revendication 1, comprenant en outre un suscepteur (4) placé sur une surface orientée vers l'ouvrage dudit élément chauffant et constitué d'un matériau contenant du carbure de silicium.

3. Unité de chauffage céramique selon la revendication 1 ou 2, comprenant en outre une plaque réfléchissante (5) placée en dessous de la surface autre que la surface orientée vers l'ouvrage dudit élément chauffant et constituée d'un matériau contenant du carbure de silicium.

4. Unité de chauffage céramique selon l'une quelconque des revendications 1 à 3, comprenant en outre une plaque isolante (6) intercalée entre ledit élément chauffant et ladite plaque réfléchissante.

5. Unité de chauffage céramique selon l'une quelconque des revendications 1 à 4, dans laquelle les éléments constituants de ladite unité de chauffage céramique sont logés dans un boîtier.

6. Unité de chauffage céramique selon l'une quelconque des revendications 1 à 5, dans laquelle ledit élément chauffant et lesdites électrodes sont formés d'un seul tenant par un procédé de frittage réactif avec utilisation du liant constitué d'un matériau contenant du carbure de silicium dans la partie qui les assemble.

7. Unité de chauffage céramique selon l'une quelconque des revendications précédentes, dans laquelle ledit liant est constitué de carbure de silicium.
